(19)

Europäisches
Patentamt
European
Patent Office
Office européen
des brevets

(11)  **EP 3 945 141 A1**

(12)  **EUROPEAN PATENT APPLICATION**

(43)  Date of publication:
**02.02.2022  Bulletin 2022/05**

(21)  Application number: **20189047.2**

(22)  Date of filing: **31.07.2020**

(51)  International Patent Classification (IPC):
**C23C 14/06** (2006.01)  **C23C 14/58** (2006.01)
**C23C 14/28** (2006.01)  **B01J 35/00** (2006.01)
**C01B 3/04** (2006.01)  **C01G 31/00** (2006.01)
**C01G 33/00** (2006.01)  **C01G 35/00** (2006.01)
**C25B 11/04** (2021.01)

(52)  Cooperative Patent Classification (CPC):
**C23C 14/0676; C01B 3/042; C01G 31/006; C01G 33/006; C01G 35/006; C23C 14/28; C23C 14/586; C25B 1/04; C25B 1/55; C25B 11/0773;** B01J 23/755; B01J 35/004; C01P 2002/72; C01P 2002/84

(84)  Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71)  Applicants:
• **TOYOTA JIDOSHA KABUSHIKI KAISHA TOYOTA-SHI, AICHI-KEN 471-8571 (JP)**
• **Helmholtz-Zentrum Berlin für Materialien und Energie GmbH 14109 Berlin (DE)**

(72)  Inventors:
• **JOHNSON, Hannah 1140 BRUSSELS (BE)**
• **KINGE, Sachin 1140 BRUSSELS (BE)**
• **VAN DE KROL, Roel BERLIN (DE)**
• **KÖLBACH, Moritz BERLIN (DE)**

(74)  Representative: **Cabinet Beau de Loménie 158, rue de l'Université 75340 Paris Cedex 07 (FR)**

Remarks:
Amended claims in accordance with Rule 137(2) EPC.

(54)  **PREPARATION OF METALLIC OXYNITRIDE THIN FILMS THROUGH AMMONOLYSIS OF PULSED LASER DEPOSITED THIN FILMS**

(57)  The present invention provides a process for forming a metallic oxynitride comprising the steps of:
(1) Pulsed Laser Deposition (PLD) of a metallic oxide; and
(2) ammonolysis of the metallic oxide prepared in step (1) to form a metallic oxynitride,
wherein the metallic oxide and the resulting metallic oxynitride both contain at least one of the following metals from group 2 of the Periodic Table: Ca, Sr, Ba; and at least one of the following metals from group 5 of the Periodic Table: V, Nb, Ta.

The metallic oxynitrides thus produced show reduced levels of impurities and defects and can notably be used in photoelectrochemical devices for water splitting.

**EP 3 945 141 A1**

**Description**

Field of the Invention

The present invention relates to a process for forming a metallic oxynitride, and to a process for the preparation of a photoelectrochemical device for water splitting comprising the preparation of a metallic oxynitride on a substrate wherein said substrate is an electrically conducting substrate, and the assembly of a photoelectrochemical device containing the electrically conducting substrate acting as a photoanode.

Background Art

Oxynitride semiconducting materials are of interest as photocatalysts and photoelectrodes for water splitting. A number of perovskite-type metal oxynitrides having two metals, or groups of metals, one in group 2 of the Periodic Table (Ca and Sr in particular) or rare earths, and the other in group 4 or 5 (such as Ti, Ta, Nb), are known to have a photocatalyst activity in water splitting, for example: such as $LaTaON_2$, $LaMg_xTa_{1-x}O_{1+3x}N_{2-3x}$, $CaTaO_2N$, $SrTaO_2N$, $BaTaO_2N$, $Sr_2Nb_2O_{7-x}N_x$, $LaTiO_2N$, $CaNbO_2N$, $SrNbO_2N$, $BaNbO_2N$, $Y_2Ta_2O_5N_2$. In particular, barium tantalum oxynitride ($BaTaO_2N$) has been studied as a photocatalyst for solar water splitting. $BaTaO_2N$ (BTON) is a suitable photoanode for oxygen evolution from water because of its band gap, which is narrow enough to absorb visible light up to 660 nm while encompassing the potentials of the hydrogen and oxygen evolution reactions.

Non-Patent Literature reference 1 (NPL) discloses thin films of barium tantalum oxynitride ($BaTaO_2N$) grown on TaN/Ta substrates via the interfacial reaction of $BaCO_3/Ta_3N_5$ layers in a $N_2$ atmosphere. A TaN thin film is first deposited on a Ta substrate by the $Ar/N_2$ ion sputtering of a Ta target, and then covered with a TaOx layer by $Ar/O_2$ sputtering. The TaOx layer is subsequently nitrided in an $NH_3$ flow to a $Ta_3N_5$ layer. Ba metal is deposited on the $Ta_3N_5$/TaN/Ta substrate under vacuum, oxidized, and carbonized to produce $BaCO_3$. A $BaTaO_2N/Ta_2N/Ta$ electrode with photoanode performance is obtained via an interfacial reaction between TaN and $BaCO_3$ layers.

NPL 2 describes annealing in an Ar flow of a $BaTaO_2N$ surface to improve its water oxidation activity. The $BaTaO_2N$ is prepared by the nitridation of $Ba_5Ta_4O_{15}$.

NPL 3 discloses $BaNbO_2N$ exhibiting photoexcitation up to 740 nm for water oxidation. NPL 4 reports a comparative investigation of particle- and thin-film-based photocatalysts using three different oxynitride materials.

NPL 5 reports the synthesis of nanostructured $BaTaO_2N$ thin films on metallic Ta substrates. A hydrothermal method was used to prepare a barium tantalum mixed oxide film on a Ta foil. $BaTaO_2N$ thin films were obtained by nitriding the oxide films under a flow of $NH_3$ at 850-1000 °C for 2 h.

NPL 6 presents a review of $H_2$ production via ammonia decomposition using non-noble metal catalysts.

NPL 7 discusses control of key processing variables (temperature, flow velocity, sample placement, temperature distribution, furnace configuration) in perovskite oxynitride synthesis in a gas-solid reaction with ammonia, in view of the competing reaction wherein ammonia dissociates to inert $N_2$, rather than a nascent, active nitriding species. The technique can be used to prepare $BaTaO_2N$ powders.

NPL 8 discloses novel barium tantalum strontium tungsten oxynitride solid solutions $(BaTaO_2N)_{1-x}(SrWO_2N)_x$, with a cubic Pm3-m perovskite-type structure (x = 0.01 and 0.02), prepared by heating oxide precursors under an ammonia flow.

NPL 9 presents a synthesis method for $BaTaO_2N$ (BTON) employing Ba-rich $LiBa_4Ta_3O_{12}$, prepared by a flux method, as a precursor used for nitridation under the flow of ammonia at a high temperature.

NPL 10 discloses a photoanode of particulate $BaTaO_2N$ fabricated by a particle transfer method and modified with a Co cocatalyst. A mixture of $BaCO_3$ and $Ta_2O_5$ powders was calcined in air at 1273 K for 10 h, resulting in the formation of $Ba_5Ta_4O_{15}$ powder; and then a BTON photocatalyst powder was obtained by nitriding the oxide precursor at 1173 K for 30 h under an $NH_3$ flow of 250 mL $min^{-1}$.

NPL 11 presents a precursor oxide having the nominal formula $(Na_{1/4}Ba_{3/4})(Zn_{1/4}Ta_{3/4})O_3$ and designed for the synthesis of $BaTaO_2N$. The precursor loses Na and Zn via evaporation during nitridation to produce $BaTaO_2N$.

NPL 12 discloses photoanodes made from $BaTaO_2N$. $BaTaO_2N$ powder was prepared by heating an amorphous $Ba_2Ta_2O_7$ precursor powder in an $NH_3$ stream (100 mL $min^{-1}$) at 1223 K for 20 h. The powder obtained was heated in a $H_2$ flow at 1073 K for 3 h, producing a material referred to as $BaTaO_2N(H_2)$. CoOx cocatalyst could be loaded on $BaTaO_2N(H_2)$ or on untreated $BaTaO_2N$ particles by impregnation from an aqueous $Co(NO_3)_2$ solution, followed by heating at 673 K for 30 min in air.

NPL 13 discloses a method to synthesize nearly single-phase powders of $BaTaO_2N$ and $CaTaO_2N$ by the heat-treatment of alkaline earth metal carbonate and tantalum (oxy)nitride in an atmosphere of $N_2$, instead of the traditional nitridation of the corresponding oxides in $NH_3$.

Meanwhile, concerning the use of Pulsed Laser Deposition (PLD), NPL 14 describes the production of low-oxygen-content zinc nitride films (ZnON) by Pulsed Laser Deposition (PLD). NPL 15 describes high-k silicon oxynitride (SiOxNy) thin films grown by means of a hybrid deposition process based on the combination of a pulsed laser deposition (PLD) plume of silicon species in an oxygen background together with a remote plasma-based atomic nitrogen source (ANS). NPL 16 describes heteroepitaxial growth of perovskite CaTaO$_2$N thin films by nitrogen plasma-assisted Pulsed Laser Deposition.

Efficient processes for producing metallic oxynitrides, in particular processes providing low levels of impurities and/or defects, are actively sought after, notably in the field of photocatalysts for solar water splitting.

Non-Patent Literature Citation List

1. Fabrication of BaTaO2N Thin Films by Interfacial Reactions of BaCO3lTa3N5 Layers on a Ta Substrate and Resulting High Photoanode Efficiencies During Water Splitting S. Nishimae et al, Sol. RRL 2020, 4, 1900542

2. Solar-Driven Water Splitting over a BaTaO2N Photoanode Enhanced by Annealing in Argon J. Seo et al., ACS Appl. Energy Mater. 2019, 2, 5777-5784

3. Efficient Solar-Driven Water Oxidation over Perovskite-Type BaNbO2N Photoanodes Absorbing Visible Light up to 740 nm J. Seo et al., Adv. Energy Mater. 2018, 8, 1800094

4. Oxynitride Thin Films versus Particle-Based Photoanodes: A Comparative Study for Photoelectrochemical Solar Water Splitting F. Haydous et al., ACS Appl. Energy Mater. 2019, 2, 1, 754-763

5. Synthesis of Nanostructured BaTaO2N Thin Films as Photoanodes for Solar Water Splitting C. Wang et al., J.Phys.Chem.C 2016, 120, 15758-15764

6. H2 Production via Ammonia Decomposition Using Non-Noble Metal Catalysts: A Review T. E. Bell, L. Torrente-Murciano, Top Catal 2016, 59, 1438-1457

7. Synthesis of BaTaO2N Powders Utilizing NH3 Decomposition M. R. Brophy et al., J. Am. Ceram. Soc., 2011, 94, 12, 4263-4268

8. Structures, electron density and characterization of novel photocatalysts, (BaTaO2N)1-x(SrWO2N)x solid solutions K. Hibino et al., Dalton Trans. 2017, 46, 14947-14956

9. Synthesis of BaTaO2N oxynitride from Ba-rich oxide precursor for construction of visible-light-driven Z-scheme overall water splitting B. Dong, Dalton-Trans., 2017, 46, 10707-10713

10. Photoelectrochemical Oxidation of Water Using BaTaO2N Photoanodes Prepared by Particle Transfer Method K. Ueda et al., J. Am. Chem. Soc. 2015, 137, 2227-2230

11. Efficient photocatalytic oxygen evolution using BaTaO2N obtained from nitridation of perovskite-type oxide S. Jadhav, J. Mater. Chem. A, 2020,8, 1127-1130

12. Fabrication of an Efficient BaTaO2N Photoanode Harvesting a Wide Range of Visible Light for Water Splitting M. Higashi, J. Am. Chem. Soc. 2013, 135, 28, 10238-10241

13. Direct synthesis of nearly single-phase BaTaO2N and CaTaO2N powders S.K. Sun, Journal of the European Ceramic Society, 2015, 35, 3289-3294

14. Zinc Oxynitride Films Prepared by Pulsed Laser Deposition R. Ayouchi, Procedia Technology, 2014, 17, 303-309

15. Growth of high-k silicon oxynitride thin films by means of a pulsed laser deposition-atomic nitrogen plasma source hybrid system for gate dielectric applications E. Desbiens, Journal of Applied Physics, 2003, 94, 5969

16. Heteroepitaxial Growth of Perovskite CaTaO2N Thin Films by Nitrogen Plasma-Assisted Pulsed Laser Deposition D. Oka, Cryst. Growth Des. 2014, 14, 1, 87-90

Summary of the Invention

With the aim of efficiently producing metallic oxynitrides, in particular with low levels of impurities and/or defects, in a first aspect, the present invention provides a process for forming a metallic oxynitride comprising the steps of:

(1) Pulsed Laser Deposition (PLD) of a metallic oxide; and
(2) ammonolysis of the metallic oxide prepared in step (1) to form a metallic oxynitride,

wherein the metallic oxide and the resulting metallic oxynitride both contain at least one of the following metals from group 2 of the Periodic Table: Ca, Sr, Ba; and at least one of the following metals from group 5 of the Periodic Table: V, Nb, Ta.

In preferred embodiments, the process of the present invention may be used to prepare metallic oxynitrides which are metal perovskite oxynitrides of formula $ABO_{2-x}N_{1+(2x/3)}$, wherein:

- A is at least one of the following metals from group 2 of the Periodic Table: Ca, Sr, Ba;
- B is at least one of the following metals from group 5 of the Periodic Table: V, Nb, Ta; and
- x is at least - 0.5 and at most 0.5, preferably at least -0.1 to 0.1, and more preferably x is 0.

Preferred target metallic oxynitrides for the process of the present invention are selected from the group consisting of: $BaTaO_2N$, $BaNbO_2N$, $SrTaO_2N$, $SrNbO_2N$, $CaTaO_2N$, and $CaNbO_2N$. Particularly preferred is barium tantalum oxynitride $BaTaO_2N$.

During step (1) of the process of the present invention, the laser fluence during the Pulsed Laser Deposition (PLD) step (1) is preferably greater than 1.5 J cm$^{-2}$ per pulse, and the partial pressure of oxygen inside the chamber used for Pulsed Laser Deposition (PLD) is preferably less than $2 \times 10^{-6}$ mbar.

In the process of the present invention, the metallic oxide is preferably deposited in Pulsed Laser Deposition (PLD) step (1) onto a substrate and step (2) forms a metallic oxynitride on said substrate. Suitable substrates may be a tantalum sheet, a niobium sheet, glassy carbon or quartz. For downstream use as a photoanode, a tantalum sheet, a niobium sheet, or glassy carbon are preferred.

In generally advantageous process embodiments of the present invention, the metallic oxide deposited in Pulsed Laser Deposition (PLD) step (1) and the metallic oxynitride formed in step (2) are both thin films of thickness at least 50 nm and at most 2000 nm, preferably at least 300 nm at most 1000 nm, most preferably at least 400 nm at most 700 nm.

In generally advantageous process embodiments of the present invention, the temperature range during ammonolysis step (2) is at least 700°C and at most 1000°C. Preferably, and notably in the preparation of barium tantalum oxynitride $BaTaO_2N$, the temperature range during ammonolysis step (2) is at least 880°C and at most 940°C, preferably at least 885°C and at most 925°C, and most preferably 890°C to 910°C, and still more preferably 900°C.

In generally advantageous process embodiments of the present invention, ammonolysis step (2) is carried out in an oven having an ammonia gas inlet and the metallic oxide samples prepared in Pulsed Laser Deposition (PLD) step (1) are placed at equal distances from and as close as possible to the ammonia gas inlet. It is further preferable in the practice of the process of the present invention that the substrate is mostly or completely coated with metallic oxide prepared in Pulsed Laser Deposition (PLD) step (1). For later preparation of a photoanode, it is preferable for the substrate to be at least partially uncoated (either by masking it during the synthesis, or by removing part of the coating after the synthesis is complete) in order to be able to make an electrical connection with the conducting substrate. However, for efficient ammonolysis, the highest possible degree of coating of the substrate is preferred.

In a second aspect, the present invention relates to a process for preparation of a photoelectrochemical device for water splitting comprising the steps of:

(A) preparation, in accordance with the first aspect of the invention as set out above, of a metallic oxynitride on a substrate wherein said substrate is an electrically conducting substrate;

(B) assembly of a photoelectrochemical device containing the electrically conducting substrate bearing metallic oxynitride of step (1) acting as a photoanode, in addition to a counter electrode, an aqueous electrolyte placed between the photoanode and the counter electrode, and an external electrical circuit linking the photoanode and the counter electrode.

In preferred embodiments of the second aspect, the counter electrode is a photocathode or metal wire.

Brief Description of the Figures

The wording "PDF" in the Figures refers to the Powder Diffraction File database, accessible on the following website: https://www.icdd.com/pdfsearch/

Figure 1 shows the results of a study of the effect of laser fluence and $O_2$ partial pressure on Ba:Ta ratio during pulsed laser deposition (PLD) of barium tantalum oxide.

Figure 2 shows an XRF map to show homogeneity of film stoichiometry during pulsed laser deposition (PLD) of barium tantalum oxide.

Figures 3 to 6 show studies on the effect of temperature of treatment by ammonia of a barium tantalum oxide to produce the corresponding oxynitride. The dotted lines in Figure 6 refer to the diffraction peaks of $BaTaO_2N$, as compared with the Powder Diffraction File database.

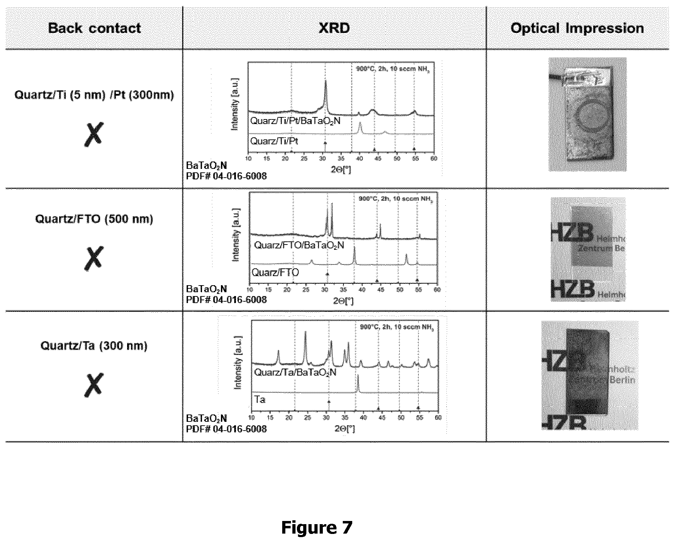

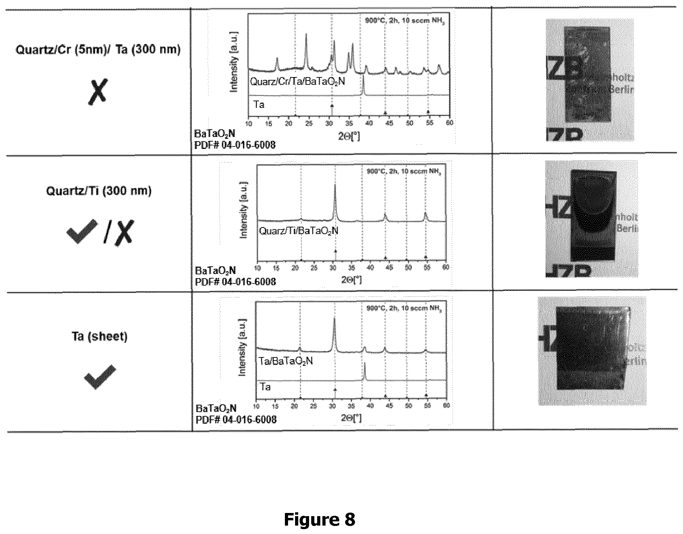

Figures 7 and 8 show studies of different conductive supports for barium tantalum oxynitride.

Figures 9- 12 show a study on nitrogen availability during ammonolysis of barium tantalum oxide to produce the corresponding oxynitride.

Figure 13 shows a study of the effect on the crystallinity of a barium tantalum oxynitride of the amount on bare substrate, i.e. substrate not coated with metallic oxide, before the ammonia reaches the metallic oxide during ammonolysis.

Figure 14 shows a photochemical cell.

Figure 15 shows photocurrent data obtained using barium tantalum oxynitride obtained through the process of the present invention and a stabilized photocurrent of a $Ta/BaTaO_2N$ film, prepared according to the present invention, without a hole scavenger.

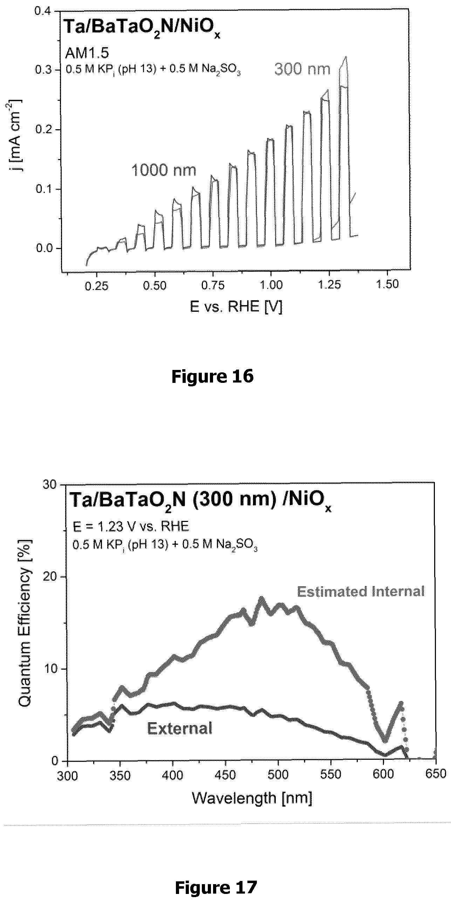

Figures 16 and 17 show, respectively, quantum efficiency, and photocurrent, generated from a $Ta/BaTaO_2N/NiOx$ photoanode, prepared according to the present invention, with a hole scavenger.

Detailed Description of the Invention

In a preferred embodiment, metallic oxynitride thin films can be prepared using the process of the present invention. The experimental parameters have been optimized in order to minimize the impurities in the thin film, as described below.

In terms of the thickness of the metallic oxynitride thin films prepared in the present invention, these may be as thin as 50 nm and as thick as 2000 nm. In order to optimise conditions of light absorption and charge separation in photoelectrochemical devices for water splitting prepared according to the present invention, preferably the metallic oxynitride thin films prepared are at least 300 nm in thickness and at most 1000 nm. More preferably the metallic oxynitride thin films prepared are at least 400 nm in thickness and at most 700 nm.

The thickness of the metallic oxynitride thin films obtained and that of the metallic oxides used to prepare them is similar and these ranges are thus also applicable to the metal oxide used for the ammonolysis reaction.

Step (1): Pulsed Laser Deposition (PLD) of a Metallic Oxide

This step uses a metallic oxide target. Material is removed from the spinning target and partially ionized with a pulsed laser. The ablated species are then deposited on a substrate. This technique allows uniform depositions with good control over the film stoichiometry (compared to conventional sputtering techniques).

In order to prepare a metallic oxide target for later treatment by Pulsed Laser Deposition (PLD), sources such as oxides and carbonates can appropriately be mixed with the required molar ratio between the two or more types of metal atoms, followed by sintering at a high temperature, for example at least 800°C. In a preferred embodiment, a $BaTaO_x$ target may be prepared by mixing barium carbonate $BaCO_3$ and tantalum oxide $Ta_2O_5$ with a molar Ba:Ta ratio of unity. More generally, carbonates or oxides of calcium (Ca), strontium (Sr) and barium (Ba), may be used, along with oxides of vanadium (V), niobium (Nb) or tantalum (Ta) to prepare metallic oxide targets for preparations of thin films by PLD in the framework of the present invention. Powders of such starting materials such as oxide and carbonate starting materials may be ground in a ball mill, pressed into a pellet with a diameter, which may in a non-limiting exemplary embodiment, be in the range of at least 25 nm and at most 51 mm, and sintered in one or more stages. Concerning powder sintering temperatures, oxide targets containing Group 2 and Group 5 metal atoms may be sintered at temperatures of at least 700°C. More preferably, temperatures of at least 800°C may be used, this range being notably suitable for preparing a $BaTaO_x$ target for synthesis of barium tantalum oxynitride $BaTaO_2N$.

In order to prepare metallic oxide films starting from such a pellet target, a substrate for depositing the film is required. Appropriate materials for an electrically conducting substrate include glassy carbon substrates, and niobium sheets or tantalum sheets. An appropriate material for a non-conducting and optically-transparent substrate is fused silica ("quartz"). Prior to deposition by PLD, such substrates may appropriately be ultrasonically cleaned in a solvent such as isopropanol, rinsed with demineralized water and dried under compressed nitrogen.

The following references review Pulsed Laser Deposition (PLD) devices and uses:

Ashfold, M. N. R.; Claeyssens, F.; Fuge, G. M.; Henley, S. J.Pulsed Laser Ablation and Deposition of Thin Films, Chem. Soc. Rev., 2004, 33, 23-31.
Lowndes, D. H.; Geohegan, D. B.; Puretzky, A. A.; Norton, D.P.; Rouleau, C. M. Synthesis of Novel Thin-Film Materials by Pulsed Laser Deposition, Science, 1996, 273, 898-903.
Krebs, H.-U.; Weisheit, M.; Faupel, J.; Süske, E.; Scharf, T.;Fuhse, C.; Störmer, M.; Sturm, K.; Seibt, M.; Kijewski, H. et al. Pulsed Laser Deposition (PLD)·A Versatile Thin Film Technique, in Advances in Solid State Physics; Kramer, B., Ed.; Springer: Berlin, Heidelberg, 2003; pp 101-107.
Blank, D. H. A.; Dekkers, M.; Rijnders, G., Pulsed Laser Deposition in Twente: From Research Tool towards Industrial Deposition. J. Phys. D: Appl. Phys. 2014, 47, No. 034006.
Greer, J. A., History and current status of commercial pulsed laser deposition equipment. J. Phys. D: Appl. Phys., 2014, 47 No. 034005

In a typical PLD procedure, a pellet target in the form of a mixed oxide as discussed above is prepared in an approximately circular shape. The pellet diameter depends in practice on various device factors such as the type of press, pressing tool, shrinking during sintering, and the PLD chamber design. A diameter of 30 mm is a typical target size for pellet targets, although between 25 mm and 51 mm diameter targets are also appropriate for use in PLD, and can be used in the present invention. Generally speaking, a pellet diameter of at least 20 mm and at most 60 mm is appropriate. Pellet sizes may thus, in exemplary embodiments, be around 2.5 cm (1 inch) in diameter, or around 30 mm in diameter. Concerning pellet thickness, in appropriate embodiments, the thickness is of a few mm (less than 1 cm). In conditions of high vacuum ($10^{-6}$ mbar), through a window, a pulsed laser beam is shone with a repetition frequency typically of around 10 Hz. Each pulse of laser energy is associated with a designed energy impact, which may be of the order of a few hundreds to ten thousand of mJ per pulse. The laser pulses impinge on the (e.g. mixed metal oxide) target material in the PLD treatment chamber, vaporizing parts of the target material in the pellet. Under the high temperature generated, a plasma plume is created and fragments of material (ions, atoms, molecular fragments), expand towards a substrate also placed in the PLD treatment chamber, and material (e.g. mixed metal oxide) material condenses on the substrate to form a thin film. The PLD treatment chamber will typically place the substrate, upon which the thin-film will be deposited during the process, approximately 5 to 10 cm away from the pellet being impacted by pulses of laser energy. In a typical configuration within the PLD treatment chamber, the pellet target is at the bottom of the chamber and the substrate hangs above. In generally appropriate conditions of execution of PLD treatment, the laser may be inclined at 30-45 degrees to horizontal. In typical reaction conditions for depositing a 25 x 25 mm² mixed oxide thin film, the number of laser pulses will be between 5,000 and 50,000 in order to prepare a thin film of thickness approximately 300 nm. A smaller maximum number of laser pulses, such as 10,000, may be sufficient for this thickness, depending on the target material. Naturally a lower or high number of laser pulses may be used to prepare, respectively, thin films of mixed oxide of lower thickness, for example 50 nm, or higher thickness, for example extending to 2000 nm.

In the PLD process, films may be appropriately deposited with a laser pulse frequency of 10 Hz, a laser spot size of $1.3 \times 2$ mm$^2$, and a target-to-substrate distance of 60 mm.

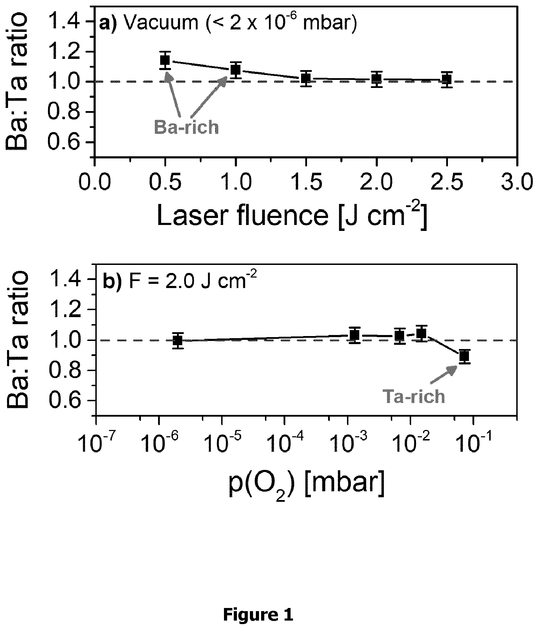

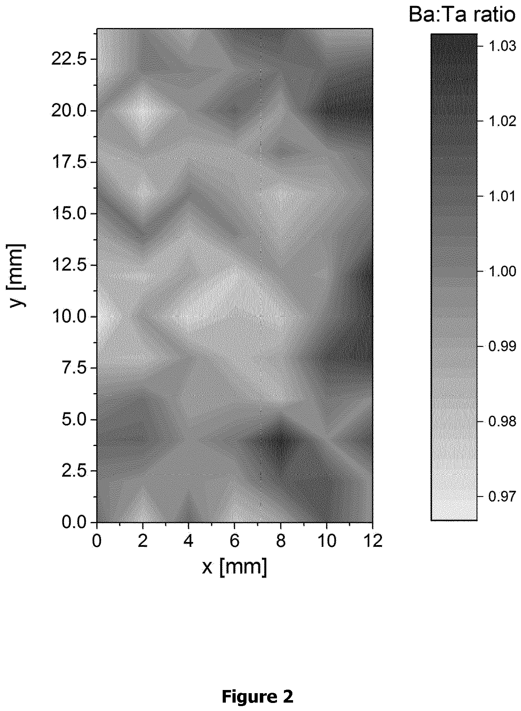

The deposition ratio can be affected by PLD process parameters, in particular the laser fluence (energy per area). Here the Ba:Ta ratio (measured with Rutherford backscattering spectrometry) can preferably be optimized to 1:1 by a laser fluence greater than 1.5 J cm$^{-2}$, this being the value per pulse. Below this, Ba-rich films may be observed. Additionally, the partial pressure of oxygen inside the chamber has an effect on the Ba:Ta ratio. Here partial pressures of oxygen of less than $2 \times 10^{-6}$ mbar are preferable to avoid the formation of Ba- or Ta-rich films. Results of studies in this field are shown in Figures 1 and 2.

The film thickness may be controlled via the number of laser shots on the BaTaO$_x$ target and measured with a Dektak profilometer. High performance for a BaTaO$_x$ target was observed with the following deposition parameters: a laser fluence of 2 J cm$^{-2}$, vacuum (< $2 \times 10^{-6}$ mbar), no substrate heating, and a target-to-substrate distance of about or exactly 60 mm. In appropriate conditions, films are post-deposition annealed, for example at 450°C for 2 h in air.

## Step (2): Ammonolysis of the metallic oxide to form a metallic oxynitride

A generally appropriate temperature range during ammonolysis step (2) is at least 700 and at most 1000 °C.

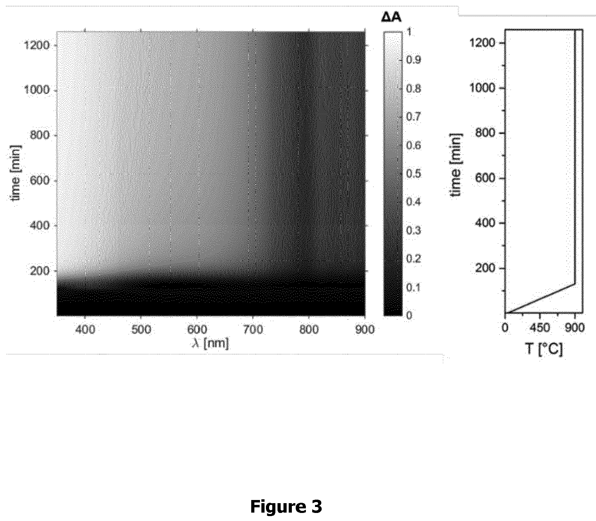

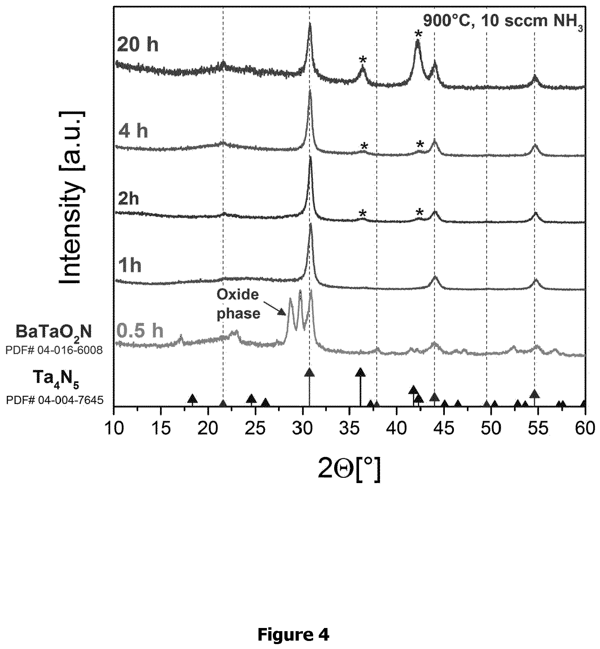

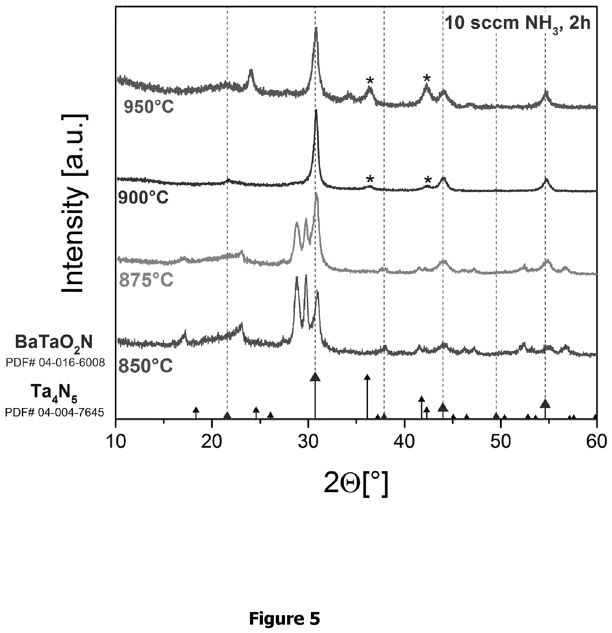

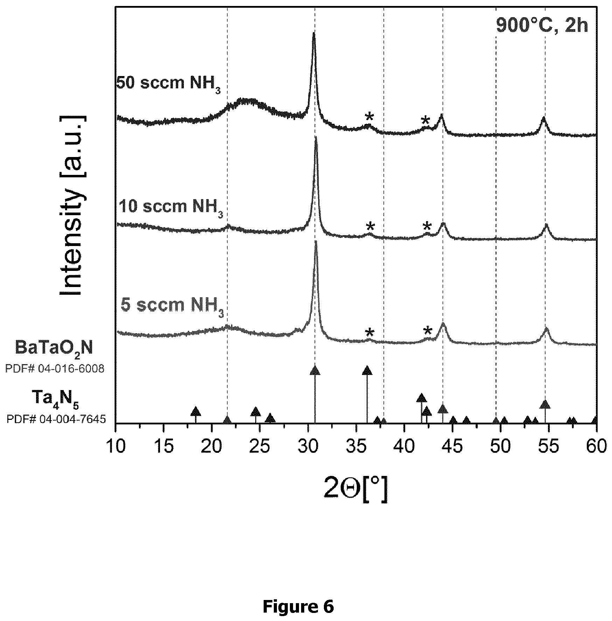

In a first part of the experimental work of the present inventors, film formation of barium tantalum oxynitride on a quartz substrate was studied. As shown in Figures 3 to 6, an annealing temperature of above 875 °C is preferred to form this oxynitride. Temperatures of around 950 °C are observed to produce the same structure but some Ta$_4$N$_5$ impurities may be introduced. Consequently a preferred temperature range of ammonolysis, in particular for preparation of barium tantalum oxynitride, is at least 880°C and at most 940°C, preferably at least 885°C and at most 925°C, and most preferably 890°C to 910°C, and still more preferably 900°C.

It is observed that an annealing time of 30 mins or less may be insufficient to convert the oxide into the oxynitride. Consequently, an annealing time of at least 1 and at most 4 hours is ideal, resulting in limited phase impurities. It is observed that annealing for longer periods (20 hours, shown here), may result in significant impurity phases (particularly tantalum nitrides).

Lower ammonia flow rates are observed to give rise to fewer tantalum nitride impurities, but the effect is weak. An appropriate flow rate of ammonia gas is at least 1 and at most 100 sccm (standard cubic centimeters per minute), preferably at least 5 and at most 100 sccm, more preferably at least 5 and at most 50 sccm. A flow rate of 10 sccm is appropriate for some preferred embodiments according to the invention.

## Conductive Substrate (for back contact)

In order to make a photoelectrochemical cell, the film should be supported on a conductive support. Therefore, the present inventors examined a variety of conductive substrates to find one compatible with BaTaO$_2$N film formation. The choice of substrate can affect the crystal structure formed, the level of phase impurities (particularly tantalum nitrides) and the adhesion of the BaTaO$_2$N to the substrate. In particular, non-conducting quartz substrates coated with Ti/Pt, FTO, Ta or Cr/Ta may result in undesired phases. In contrast, quartz coated with a conducting Ti film gives a significantly purer phase but the sample did not generate a significant photocurrent. A metallic Ta sheet was found to give the best results in terms of both phase purity and adhesion.

## Ammonolysis on Ta substrate: Configuration of Samples in Oven

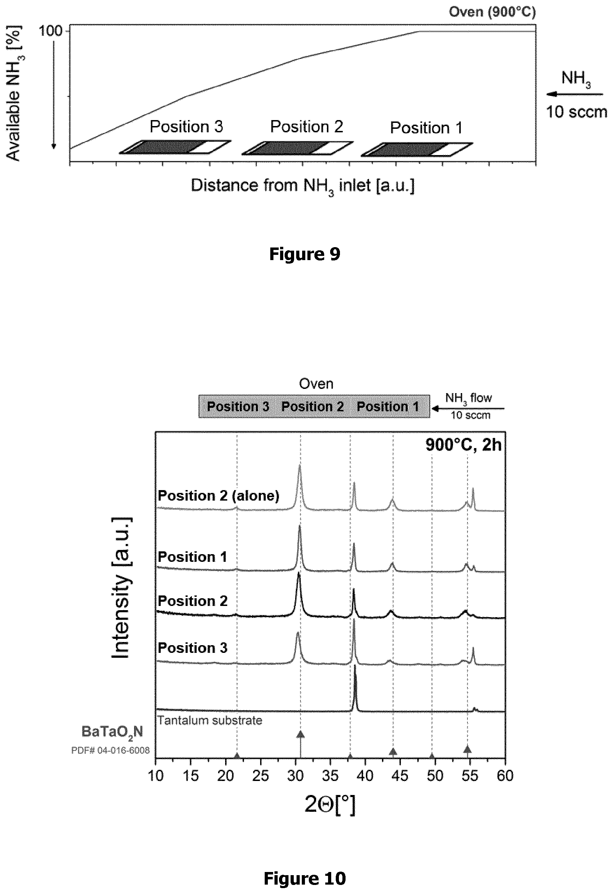

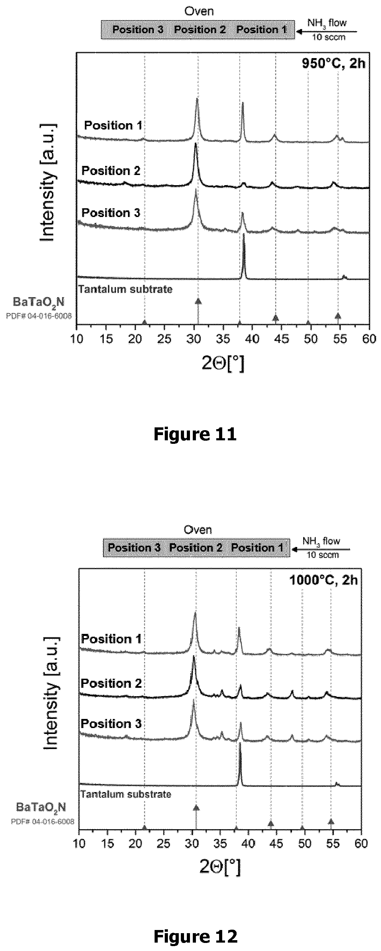

Over different ammonolysis temperatures, an effect of the sample position in the oven may be observed - results are shown in Figures 9-12. Samples closest to the ammonia inlet tend to have the highest crystallinity, with crystallinity decreasing downstream towards the back of the oven. This is likely due to the ammonia cracking reaction $\left(NH_3 \rightarrow \frac{1}{2} N_2 + \frac{3}{2} H_2\right)$ as it travels through the furnace (as described in Brophy et al., J. Am. Ceram. Soc., 94, 12, 4263-4268 (2011)). Therefore it is preferable (where the furnace is sufficiently large to allow this), to have samples placed at equal distances from (and as close as possible to) the NH$_3$ inlet or ammonolyse samples individually.

## Effect of non-coated substrate

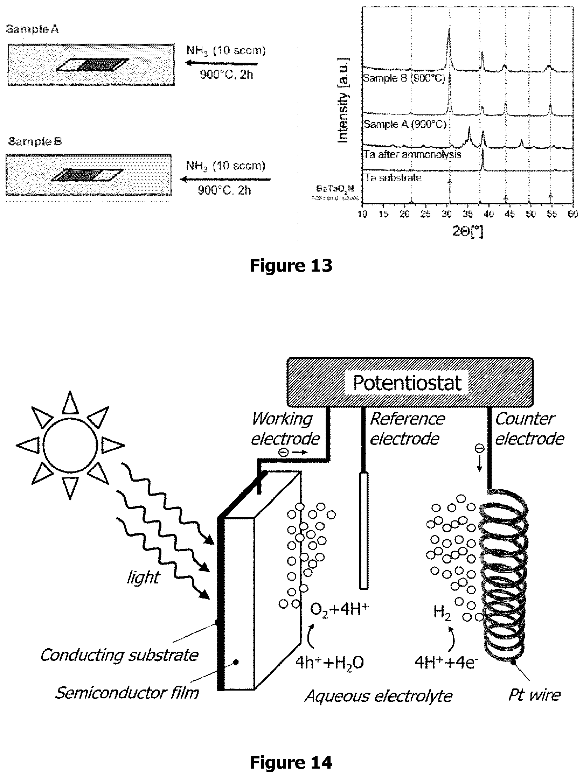

Further tests showed that the crystallinity of the sample is significantly affected by the amount of bare substrate, i.e. substrate not coated with metallic oxide, before the ammonia reaches the metallic oxide. Where there is a large amount of bare substrate exposed upstream of the metallic oxide, the sample is less crystalline and vice-versa. A result of a study of this aspect is shown in Figure 13. In line with the results from the configuration of the samples in the oven, this is likely due to the partial (but significant) consumption of ammonia by the catalytic cracking of ammonia to N$_2$ and H$_2$ by the tantalum substrate. Consequently, it is preferred that the substrate, particularly in zone(s) close to the ammonia inlet, is mostly or completely coated with metallic oxide.

## Photoelectrochemical Measurement

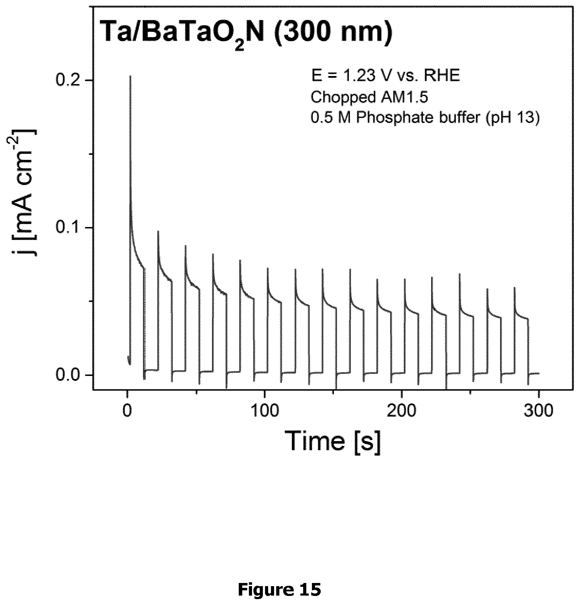

Barium tantalum oxynitride $BaTaO_2N$ prepared by the method of the present invention has been demonstrated in a photoelectrochemical cell. The bare $BaTaO_2N$ was assessed in terms of performance using a pulsed laser deposition under conditions (stabilized AM1.5 photocurrent with no hole scavenger) used in the prior art (NPL 4 cited above) - the raw photocurrent data is shown in Figure 15. The material obtained in the present invention showed a greater than 50 times increase in photocurrent.

The performance could be further enhanced by addition of a $NiO_x$ co-catalyst (as described in experimental methods) in the same photoelectrochemical set-up as shown in the quantum efficiency measurements and photocurrent measurements below.

## **Examples**

### 1. Film preparation

### 1.1 Pulsed laser deposition (PLD) of $BaTaO_x$ thin films

$BaTaO_x$ thin films were prepared in a custom-built PLD system from PREVAC equipped with a KrF-excimer laser ($\lambda$ = 248 nm, LPX Pro210, Coherent).

### 1.1.1 Metallic oxide target preparation

The $BaTaO_x$ target was prepared by mixing $BaCO_3$ (99.997%, Alfa Aesar) and $Ta_2O_5$ (99.993%, Alfa Aesar) with a molar Ba:Ta ratio of unity. The powders were grounded in a ball mill (Fritsch Pulverisette) for 1 h using a zirconia grinding bowl and ball. Subsequently, the mixed powder was pressed into a pellet with a diameter of 30 mm and sintered in a tube furnace at 850°C for 8 h in air. The obtained pellet was ground again and sintered at 850°C for 12 h. This process was repeated further two times with a sintering time of 10 h and temperatures of 950°C and 1150°C, respectively.

### 1.1.2 Metallic oxide thin film preparation by PLD

Films were deposited on glassy carbon substrates (5 $\times$ 10 mm$^2$, Sigradur G, HTW), on quartz substrates (12 $\times$ 25 mm$^2$, Spectrosil 2000, Baumbauch & Co LTD) and on Tantalum sheets (12 $\times$ 25 mm$^2$). Prior to deposition, the substrates were ultrasonically cleaned in isopropanol for 10 min, rinsed with demineralized water and dried under compressed nitrogen. Films were deposited with a laser pulse frequency of 10 Hz, a laser spot size of 1.3 $\times$ 2 mm$^2$, and a target-to-substrate distance of 60 mm. The film thickness was controlled via the number of laser shots on the $BaTaO_x$ target and

measured with a Dektak profilometer. The deposition parameters were optimized to a laser fluence of 2 J cm$^{-2}$, vacuum (< 2 $\times$ 10$^{-6}$ mbar), no substrate heating, and a target-to-substrate distance of 60 mm. All films were post-deposition annealed at 450°C for 2 h in air.

### 1.2 Ammonolysis of $BaTaO_x$ to form $BaTaO_2N$

Ammonolysis of the $BaTaO_x$ films was performed in a furnace equipped with a fused silica reactor tube. Prior to starting the ammonolysis process, the setup was thoroughly flushed with $NH_3$ (about 10 times the volume of the whole setup). The temperature ramp rate was set to 7°C min$^{-1}$. After the ammonolysis, the oven was turned off and the samples were cooled down to room temperature under flowing $NH_3$. The ammonolysis parameters were optimized to a temperature of 900°C, a $NH_3$ flow rate of 10 sccm, and an annealing time of 2 h.

### 1.3 Deposition of $NiO_x$ co-catalyst

$NiO_x$ film with a thickness of 20 nm was pulsed laser deposited onto Ta/$BaTaO_2N$ films by ablating a Ni target (99.99%, Alfa Aesar) with a laser fluence of 2 J cm$^{-2}$. The oxygen background pressure was set to $p(O_2)$ = 5 $\times$ 10$^{-2}$ mbar and a target-to-substrate distance of 60 mm was used. During the process, the substrate was not heated.

### 2. Film characterization

### 2.1 Rutherford backscattering spectrometry

The Ba:Ta ratio of the films deposited on glassy carbon was determined using Rutherford backscattering spectrometry (RBS). $^4$He-ions (1700 keV) were used as a probe and the energy distribution of the backscattered ions was measured at a scattering angle of 170°. The spectra were analyzed with the SIMNRA software.

### 2.2 X-ray fluorescence spectroscopy

RBS-calibrated XRF analysis was conducted using a Bruker M4 Tornado equipped with a Rh-tube and a poly-capillary optic with a spot size of 20 $\mu$m.

### 2.3 In-situ UV-vis analysis

For the in-situ UV-vis analysis, the same oven and setup as for the ammonolysis process was used (see 1.2). The quartz/$BaTaO_x$ film was illuminated through an optical window in the quartz tube by a deuterium-halogen lamp (DH-2000-BAL, Ocean Optics) via an optical fiber / collimator assembly. The diameter of the light beam was ~5 mm. The transmitted light was collected by another optical fiber /collimator assembly and delivered to a spectrometer (MAYA 2000-Pro, Ocean Optics) from which the change in the optical absorption can be determined as a function of time.

2.4 X-ray diffraction

X-ray diffraction (XRD) analysis of the thin films was performed with a Bruker D8 Advance diffractometer in a grazing incidence geometry. The Cu K$\alpha$ X-ray source ($\lambda$ = 1.5406 Å) was operated at 40 kV and 40 mA. Measurements were conducted with a step size of 0.02° and an integration time of 5 s per step.

2.5 Photoelectrochemical characterization

Photoelectrochemical characterization of the films were performed in a cell with a three-electrode arrangement consisting of a platinum counter electrode, an Ag/AgCl reference electrode (XR300, Radiometer), and the Ta/BaTaO$_2$N film as the working electrode. For measurements under AM1.5 illumination, an EG&G Princeton Applied Research (Model 273A) potentiostat and a WACOM Super Solar Simulator (Model WXS-505-5H, AM1.5, Class AAA) that closely matched the AM1.5 global spectrum (100 mW cm$^{-2}$) were used. The electrolyte was an aqueous 0.5 M KPi (pH 13) buffer solution prepared from K$_2$HPO$_4$ ($\geq$ 99.0%, Sigma Aldrich) and KOH (99.99%, Sigma Aldrich). For some experiments, 0.5 M Na$_2$SO$_3$ (99%, Sigma-Aldrich) was added as a hole scavenger. All potentials were referred to the reversible hydrogen electrode (RHE) calculated from the potential of the reference electrode ($E_{Ag/AgCl}$ = +0.199 V), the measured potential ($E_{measured}$), and the pH of the electrolyte solution according to $E_{RHE} = E_{measured} + E_{Ag/AgCl} + 0.059$ $pH$. Incident photon-to-current efficiency (IPCE) measurements were performed with a Xe lamp (LOT, LSH302), an Acton Research monochromator (Spectra Pro 2155), and an electronic shutter (Uniblitz LS6). To remove higher higher-order diffracted light, a long-pass colored filter (Schott, 3 mm thick) was placed between the monochromator and the sample. The incident light intensity was determined by placing a quartz substrate instead of the Ta/BaTaO$_2$N film in the PEC cell, filling the cell with electrolyte, and then measuring the transmitted light with a photodiode (PD300R-UV, Ophir).

**Claims**

1. Process for forming a metallic oxynitride comprising the steps of:

    (1) Pulsed Laser Deposition (PLD) of a metallic oxide; and
    (2) ammonolysis of the metallic oxide prepared in step (1) to form a metallic oxynitride,

    wherein the metallic oxide and the resulting metallic oxynitride both contain at least one of the following metals from group 2 of the Periodic Table: Ca, Sr, Ba; and at least one of the following metals from group 5 of the Periodic Table: V, Nb, Ta.

2. Process according to claim 1, wherein the metallic oxynitride obtained is a metal perovskite oxynitride of formula ABO$_{2-x}$N$_{1+(2x/3)}$, wherein:

    - A is at least one of the following metals from group 2 of the Periodic Table: Ca, Sr, Ba;
    - B is at least one of the following metals from group 5 of the Periodic Table: V, Nb, Ta; and
    - x is at least - 0.5 and at most 0.5, preferably at least -0.1 to 0.1, and more preferably x is 0.

3. Process according to claim 1 or 2, wherein the metallic oxynitride obtained is selected from the group consisting of: BaTaO$_2$N, BaNbO$_2$N, SrTaO$_2$N, SrNbO$_2$N, CaTaO$_2$N, and CaNbO$_2$N.

4. Process according to any of claims 1 to 3, wherein the metallic oxynitride obtained is barium tantalum oxynitride BaTaO$_2$N.

5. Process according to any of claims 1 to 4, wherein the laser fluence during the Pulsed Laser Deposition (PLD) step (1) is greater than 1.5 J cm$^{-2}$.

6. Process according to any of claims 1 to 5, wherein the partial pressure of oxygen inside the chamber used for Pulsed Laser Deposition (PLD) step (1) is less than 2 × 10$^{-6}$ mbar.

7. Process according to any of claims 1 to 6, wherein the metallic oxide is deposited in Pulsed Laser Deposition (PLD) step (1) onto a substrate and step (2) forms a metallic oxynitride on said substrate.

8. Process according to claim 7, wherein the substrate is a tantalum sheet, a niobium sheet, glassy carbon or an optically-transparent, non-conducting fused silica ("quartz").

9. Process according to any of claims 1 to 8, wherein the metallic oxide deposited in Pulsed Laser Deposition (PLD) step (1) and the metallic oxynitride formed in step (2) are both thin films of thickness at least 50 nm and at most 2000 nm, preferably at least 300 nm and at most 1000 nm, more preferably at least 400 nm and at most 700 nm.

10. Process according to any of claims 1 to 9, wherein the temperature range during ammonolysis step (2) is at least 700°C and at most 1000°C.

11. Process according to claim 10, wherein the temperature range during ammonolysis step (2) is at least 880°C and at most 940°C, preferably at least 885°C and at most 925°C, and most preferably 890°C to 910°C, and still more preferably 900°C.

12. Process according to any of claims 1 to 11, wherein ammonolysis step (2) is carried out in an oven having an ammonia gas inlet and the metallic oxide samples prepared in Pulsed Laser Deposition (PLD) step (1) are placed at equal distances from and/or as close as possible to the ammonia gas inlet.

13. Process according to any of claims 7 to 12, wherein the substrate is mostly or completely coated with metallic oxide prepared in Pulsed Laser Deposition (PLD) step (1).

14. Process for preparation of a photoelectrochemical device for water splitting comprising the steps of:

(A) preparation in accordance with any of claims 7 to 13 of a metallic oxynitride on a substrate wherein said substrate is an electrically conducting substrate;
(B) assembly of a photoelectrochemical device containing the electrically conducting substrate bearing metallic oxynitride of step (1) acting as a photoanode, in addition to a counter electrode, an aqueous electrolyte placed between the photoanode and the counter electrode, and an external electrical circuit linking the photoanode and the counter electrode.

15. Process for preparation of a photoelectrochemical device according to claim 14, wherein the counter electrode is a photocathode or metal wire.

**Amended claims in accordance with Rule 137(2) EPC.**

1. Process for forming a metallic oxynitride comprising the steps of:

(1) Pulsed Laser Deposition (PLD) of a metallic oxide; and
(2) ammonolysis of the metallic oxide prepared in step (1) to form a metallic oxynitride,

wherein the metallic oxide and the resulting metallic oxynitride both contain Ba and Ta, and the metallic oxynitride obtained is barium tantalum oxynitride $BaTaO_2N$, and
wherein the temperature range during ammonolysis step (2) is at least 700°C and at most 1000°C.

2. Process according to claim 1, wherein the laser fluence during the Pulsed Laser Deposition (PLD) step (1) is greater than 1.5 J cm$^{-2}$.

3. Process according to claim 1 or 2, wherein the partial pressure of oxygen inside the chamber used for Pulsed Laser Deposition (PLD) step (1) is less than $2 \times 10^{-6}$ mbar.

4. Process according to any of claims 1 to 3, wherein the temperature range during ammonolysis step (2) is at least 880°C and at most 940°C, preferably at least 885°C and at most 925°C, and most preferably 890°C to 910°C, and still more preferably 900°C.

5. Process according to any of claims 1 to 4, wherein ammonolysis step (2) is carried out in an oven having an ammonia gas inlet and the metallic oxide samples prepared in Pulsed Laser Deposition (PLD) step (1) are placed at equal distances from and/or as close as possible to the ammonia gas inlet.

6. Process according to any of claims 1 to 5, wherein the metallic oxide deposited in Pulsed Laser Deposition (PLD) step (1) and the metallic oxynitride formed in step (2) are both thin films of thickness at least 50 nm and at most 2000 nm, preferably at least 300 nm and at most 1000 nm, more preferably at least 400 nm and at most 700 nm.

7. Process according to any of claims 1 to 6, wherein ammonolysis step (2) is carried out for at least 1 and at most 4 hours.

8. Process according to any of claims 1 to 7, wherein ammonolysis step (2) is carried out with a flow rate of ammonia gas of at least 1 and at most 100 sccm (standard cubic centimeters per minute).

9. Process according to any of claims 1 to 8, wherein the metallic oxide is deposited in Pulsed Laser Deposition (PLD) step (1) onto a substrate and step (2) forms a metallic oxynitride on said substrate.

10. Process according to claim 9, wherein the substrate is a tantalum sheet, a niobium sheet, glassy carbon or an optically-transparent, non-conducting fused silica ("quartz").

11. Process according to claim 9 or 10, wherein the substrate is mostly or completely coated with metallic oxide prepared in Pulsed Laser Deposition (PLD) step (1).

12. Process for preparation of a photoelectrochemical device for water splitting comprising the steps of:

(A) preparation in accordance with any of claims 9 to 11 of a metallic oxynitride on a substrate wherein said substrate is an electrically conducting substrate;
(B) assembly of a photoelectrochemical device containing the electrically conducting substrate bearing metallic oxynitride of step (1) acting as a photoanode, in addition to a counter electrode, an aqueous electrolyte placed between the photoanode and the counter electrode, and an external electrical circuit linking the photoanode and the counter electrode.

13. Process for preparation of a photoelectrochemical device according to claim 12, wherein the counter electrode is a photocathode or metal wire.

**Figure 1**

Figure 2

**Figure 3**

EP 3 945 141 A1

**Figure 4**

14

**Figure 5**

**Figure 6**

| Back contact | XRD | Optical Impression |
|---|---|---|
| Quartz/Ti (5 nm) /Pt (300nm)  ✗ | | |
| Quartz/FTO (500 nm)  ✗ | | |
| Quartz/Ta (300 nm)  ✗ | | |

**Figure 7**

**Figure 8**

Figure 9

Figure 10

**Figure 11**

**Figure 12**

**Figure 13**

**Figure 14**

**Figure 15**

**Figure 16**

**Figure 17**

Europäisches
Patentamt

European
Patent Office

Office européen
des brevets

# EUROPEAN SEARCH REPORT

Application Number

EP 20 18 9047

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/073229 A1 (JAPAN SCIENCE & TECH AGENCY [JP]) 16 March 2017 (2017-03-16) | 1,5-9, 12,13 | INV. C23C14/06 |
| Y | * paragraph [0034]; example 2 * | 14,15 | C23C14/58 C23C14/28 |
| Y | KOICHIRO UEDA ET AL: "Photoelectrochemical Oxidation of Water Using BaTaO 2 N Photoanodes Prepared by Particle Transfer Method", JOURNAL OF THE AMERICAN CHEMICAL SOCIETY, vol. 137, no. 6, 18 February 2015 (2015-02-18), pages 2227-2230, XP055754804, US ISSN: 0002-7863, DOI: 10.1021/ja5131879 * page 2229; figure 5 * | 14,15 | B01J35/00 C01B3/04 C01G31/00 C01G33/00 C01G35/00 C25B11/04 |
| Y | EP 3 382 726 A1 (TDK CORP [JP]) 3 October 2018 (2018-10-03) * paragraphs [0037] - [0048]; examples 1,5 * | 1-15 | |
| Y | ROSIANA AGUIAR ET AL: "Physical properties of (La,Sr)Ti(O,N)3 thin films grown by pulsed laser deposition", MATERIALS RESEARCH BULLETIN, vol. 43, no. 6, 1 June 2008 (2008-06-01), pages 1376-1383, XP055754767, GB ISSN: 0025-5408, DOI: 10.1016/j.materresbull.2007.06.049 * Paragraph "Experimental" * | 1-15 | TECHNICAL FIELDS SEARCHED (IPC) C23C B01J C01C C01B C01G C25B |

The present search report has been drawn up for all claims

| Place of search | Date of completion of the search | Examiner |
|---|---|---|
| The Hague | 27 November 2020 | Schwake, Andree |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 20 18 9047

This annex lists the patent family members relating to the patent documents cited in the above-mentioned European search report.
The members are as contained in the European Patent Office EDP file on
The European Patent Office is in no way liable for these particulars which are merely given for the purpose of information.

27-11-2020

| Patent document cited in search report | | | Publication date | Patent family member(s) | | | Publication date |
|---|---|---|---|---|---|---|---|
| US 2017073229 | A1 | | 16-03-2017 | JP | 6509194 | B2 | 08-05-2019 |
| | | | | JP | WO2015136953 | A1 | 06-04-2017 |
| | | | | US | 2017073229 | A1 | 16-03-2017 |
| | | | | WO | 2015136953 | A1 | 17-09-2015 |
| EP 3382726 | A1 | | 03-10-2018 | CN | 108695063 | A | 23-10-2018 |
| | | | | EP | 3382726 | A1 | 03-10-2018 |
| | | | | KR | 20180111687 | A | 11-10-2018 |
| | | | | US | 2018282228 | A1 | 04-10-2018 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **S. NISHIMAE et al.** Fabrication of BaTaO2N Thin Films by Interfacial Reactions of BaCO3ITa3N5 Layers on a Ta Substrate and Resulting High Photoanode Efficiencies During Water Splitting. *Sol. RRL,* 2020, vol. 4, 1900542
- **J. SEO et al.** Solar-Driven Water Splitting over a BaTaO2N Photoanode Enhanced by Annealing in Argon. *ACS Appl. Energy Mater.,* 2019, vol. 2, 5777-5784
- **J. SEO et al.** Efficient Solar-Driven Water Oxidation over Perovskite-Type BaNbO2N Photoanodes Absorbing Visible Light up to 740 nm. *Adv. Energy Mater.,* 2018, vol. 8, 1800094
- **F. HAYDOUS et al.** Oxynitride Thin Films versus Particle-Based Photoanodes: A Comparative Study for Photoelectrochemical Solar Water Splitting. *ACS Appl. Energy Mater.,* 2019, vol. 2 (1), 754-763
- **C. WANG et al.** Synthesis of Nanostructured BaTaO2N Thin Films as Photoanodes for Solar Water Splitting. *J.Phys.Chem.C,* 2016, vol. 120, 15758-15764
- **T. E. BELL ; L. TORRENTE-MURCIANO.** H2 Production via Ammonia Decomposition Using Non-Noble Metal Catalysts: A Review. *Top Catal,* 2016, vol. 59, 1438-1457
- **M. R. BROPHY et al.** Synthesis of BaTaO2N Powders Utilizing NH3 Decomposition. *J. Am. Ceram. Soc.,* 2011, vol. 94 (12), 4263-4268
- **K. HIBINO et al.** Structures, electron density and characterization of novel photocatalysts, (BaTaO2N)1-x(SrWO2N)x solid solutions. *Dalton Trans.,* 2017, vol. 46, 14947-14956
- **B. DONG.** Synthesis of BaTaO2N oxynitride from Ba-rich oxide precursor for construction of visible-light-driven Z-scheme overall water splitting. *DaltonTrans.,* 2017, vol. 46, 10707-10713
- **K. UEDA et al.** Photoelectrochemical Oxidation of Water Using BaTaO2N Photoanodes Prepared by Particle Transfer Method. *J. Am. Chem. Soc.,* 2015, vol. 137, 2227-2230
- **S. JADHAV.** Efficient photocatalytic oxygen evolution using BaTaO2N obtained from nitridation of perovskite-type oxide. *J. Mater. Chem. A,* 2020, vol. 8, 1127-1130

- **M. HIGASHI.** Fabrication of an Efficient BaTaO2N Photoanode Harvesting a Wide Range of Visible Light for Water Splitting. *J. Am. Chem. Soc.,* 2013, vol. 135 (28), 10238-10241
- **S.K. SUN.** Direct synthesis of nearly single-phase BaTaO2N and CaTaO2N powders. *Journal of the European Ceramic Society,* 2015, vol. 35, 3289-3294
- **R. AYOUCHI.** Zinc Oxynitride Films Prepared by Pulsed Laser Deposition. *Procedia Technology,* 2014, vol. 17, 303-309
- **E. DESBIENS.** Growth of high-k silicon oxynitride thin films by means of a pulsed laser deposition-atomic nitrogen plasma source hybrid system for gate dielectric applications. *Journal of Applied Physics,* 2003, vol. 94, 5969
- **D. OKA.** Heteroepitaxial Growth of Perovskite CaTaO2N Thin Films by Nitrogen Plasma-Assisted Pulsed Laser Deposition. *Cryst. Growth Des.,* 2014, vol. 14 (1), 87-90
- **ASHFOLD, M. N. R. ; CLAEYSSENS, F. ; FUGE, G. M. ; HENLEY, S. J.** Pulsed Laser Ablation and Deposition of Thin Films. *Chem. Soc. Rev.,* 2004, vol. 33, 23-31
- **LOWNDES, D. H. ; GEOHEGAN, D. B. ; PURETZKY, A. A. ; NORTON, D.P. ; ROULEAU, C. M.** Synthesis of Novel Thin-Film Materials by Pulsed Laser Deposition. *Science,* 1996, vol. 273, 898-903
- Pulsed Laser Deposition (PLD)·A Versatile Thin Film Technique. **KREBS, H.-U. ; WEISHEIT, M. ; FAUPEL, J. ; SÜSKE, E. ; SCHARF, T. ; FUHSE, C. ; STÖRMER, M. ; STURM, K. ; SEIBT, M. ; KIJEWSKI, H. et al.** Advances in Solid State Physics. Springer, 2003, 101-107
- **BLANK, D. H. A. ; DEKKERS, M. ; RIJNDERS, G.** Pulsed Laser Deposition in Twente: From Research Tool towards Industrial Deposition. *J. Phys. D: Appl. Phys.,* 2014, vol. 47 (034006
- **GREER, J. A.** History and current status of commercial pulsed laser deposition equipment. *J. Phys. D: Appl. Phys.,* 2014, vol. 47 (034005
- **BROPHY et al.** *J. Am. Ceram. Soc.,* 2011, vol. 94 (12), 4263-4268